# EUROPEAN PATENT APPLICATION

(11) **EP 2 431 683 A1**
(43) Date of publication of application: **21.03.2012**
(21) Application number: 10774576.2
(22) Date of filing: 13.04.2010
(51) Int. Cl.: F24J 2/54

(54) **SINGLE-AXIS SOLAR TRACKER AND SOLAR POWER INSTALLATION**

(30) Priority: 11.05.2009 ES 200901188
(71) Applicant: Soltec Energías Renovables, SL, 30500 Molina de Segura (Murcia) (ES)
(72) Inventor: GRANT, Thomas, E-30500 Molina de Segura (Murcia) (ES); MORALES TORRES, Raúl, E-30500 Molina de Segura (Murcia) (ES)
(74) Representative: Torner Lasalle, Elisabet
(86) International application number: PCT/ES2010/000155
(87) International publication number: WO 2010/130847

(57) **Abstract**

The present invention relates to a single-axis solar tracker and solar power installation. The tracker comprising:
- a row H1 of coplanar and adjacent solar panels P secured to a horizontal common rotating shaft E1;
- a support structure wherein said common rotating shaft E1 is rotatably mounted,
- actuation means with a geared motor M in connection with a part P1 in the form of a circular sector secured to the common rotating shaft E1, and
- a support base B1 attached to the ground wherein said support structure and said geared motor M are secured.

The solar power installation comprises the solar tracker proposed with its actuation mechanism in mechanical connection with a series of actuation mechanisms of other solar trackers included in the installation.

## Description

### Sector of the Art

In a first aspect the present invention generally relates to a single-axis solar tracker of those comprising a series of solar panels which are oriented with respect to the orientation of the sun pivoting about a common shaft by means of an actuation mechanism including a geared motor, for the purpose of obtaining the greatest possible incidence of solar radiation over the solar panels at all times, and particularly to a solar tracker the geared motor of which is secured to a support base of the solar tracker.

A second aspect of the invention relates to a solar power installation comprising the solar tracker proposed by the first aspect with its actuation mechanism in mechanical connection with a series of actuation mechanisms of other solar trackers included in the installation.

### Prior State of the Art

Many single-axis solar trackers with different structural configurations and actuation mechanisms are known.

Patent EP1169604B1 describes a single-axis solar tracker supported by a post secured to a first support base, and which comprises actuation means secured to a second support base distanced from the first.

Utility model ES-A-1046171 also describes one such single-axis solar tracker, which comprises a mechanism responsible for pivoting a shaft of several solar panels, formed by a towline guided by pulleys displacing a semicircular part coupled to said shaft.

Said utility model describes a device including a geared motor displacing a linear actuator, inside of which the mentioned towline is driven, the ends of which are secured in said semicircular part.

Both the geared motor and the linear actuator are arranged on the same support structure in which the solar panels are rotatably mounted through a common rotating shaft.

In addition a biaxial tracker which uses an actuation mechanism similar to that of utility model ES-A-1046171 for inclining the rows of solar panels that it supports, but with the difference that instead using a towline which travels along pulleys for displacing the semicircular part coupled to the shaft of the solar panels, it uses a chain displaced by a corresponding motor along gears or cogwheels, is also known through application ES-A-2308910, property of the present applicant.

The present inventors are not aware of single-axis solar trackers the actuation- means of which include a semicircular part as those described in two of the above mentioned patent documents where the geared motor responsible for displacing is secured to the same support base to which is secured the support structure of the solar panels.

### Summary of the Invention

It is necessary to offer an alternative to the state of the art which covers the gaps found in the same indicated in the previous section.

To that end, in a first aspect, the present invention relates to a single-axis solar tracker comprising, is a known manner:
- a row of coplanar and adjacent solar panels secured to a horizontal common rotating shaft;
- a support structure in which said common rotating shaft is rotatably mounted,
- actuation means for rotating said common rotating shaft for the purpose of orienting said row of solar panels with respect to the position of the sun, said actuation means comprising a geared motor in connection with a part in the form of a circular sector secured to said common rotating shaft, coaxially with the same or with its geometric axis slightly displaced therefrom.

Unlike the conventional proposals the solar tracker proposed by the present invention comprises a support base attached to the ground in which both said support structure and said geared motor is secured.

In general the geared motor is secured to the support base such that the output rotation shaft thereof, or the shaft of an outer reducing stage if it is the case, is aligned with the common rotating shaft in the same vertical plane, or slightly displaced.

For some embodiments the tracker proposed comprises more than one row of solar panels, and more than one support structure.

In the solar tracker proposed by the first aspect of the invention, the width of each panel, transversally to the mentioned common rotating shaft, i.e. the width of the row of panels, is advantageously greater than the distance between the common rotating shaft and the support base which is secured to the ground.

Moreover, since the solar tracker proposed by the invention does not include a linear actuator, in contrary to the tracker of the utility model ES-A-1046171, the width occupied by the actuation means is also considerably reduced in comparison with said utility model, and the stresses suffered by the support structure is reduced, which in the case of said utility model, are much greater due to the said support structure supporting the geared motor and the linear actuator associated thereto.

With such dimensioning the solar tracker proposed will have a very small height in comparison with the known single-axis solar trackers, causing a greater compactness, and above all the torque exerted by the geared motor for displacing the semicircular part, and thereby the solar panels, is moreover much lower than that needed for inclining the solar panels of the taller conventional trackers.

A second aspect of the present invention relates to a solar power installation comprising a solar tracker like that proposed by the first aspect of the invention, a plurality of analogous solar trackers both which lack a geared motor, and transmission mechanisms for transmitting the rotation of the geared motor of the solar tracker of the present invention to all the other solar trackers.

Both the solar tracker proposed by the first aspect and the solar power installation proposed by the second aspect are applied to harness solar energy for any known purpose, from that referring to the obtaining of electrical energy, i.e. in the field of photovoltaic, to that referring to the heating of a fluid circulating through pipes heated by the solar panels.

### Brief Description of the Drawings

The foregoing and other advantages and features will be better understood from the following detailed description of several embodiments in reference to the attached drawings which must be interpreted in an illustrative and non-limiting manner, in which:
Figures 1A and 1B are respective elevational side views showing the solar tracker proposed by the first aspect of the present invention from two opposite sides, for an embodiment, as well as part of two connecting rods forming part of a transmission mechanism provided for mechanically interconnecting the proposed solar tracker with two other solar trackers;
Figure 2 is a view similar to that of Figure 1 but for another alternative embodiment for which the proposed solar tracker has a support structure different from that of Figure 1;
Figure 3 is an elevational side view showing the solar tracker of Figure 1 with a rail secured to the support base of another solar tracker, through which the geared motor has been removed in a guided manner from the proposed solar tracker to the maintenance position illustrated;
Figure 4 is a perspective view which illustrates part of the solar power installation proposed by the second aspect of the invention, including two adjacent solar trackers, illustrated in part, one of which is that proposed by the first aspect of the invention according to the embodiment of Figures 1 and 3;
Figure 5 is an elevational side view of the solar power installation proposed by the invention, for an embodiment for which the latter comprises five solar trackers, one of which, the central one, is the one proposed by the first aspect of the invention; and
Figure 6 is a plan view of the solar power installation proposed by the second aspect of the invention, for the same embodiment of Figure 5, wherein each solar tracker comprises a row formed by twenty-six solar panels.

### Detailed Description of Several Embodiments

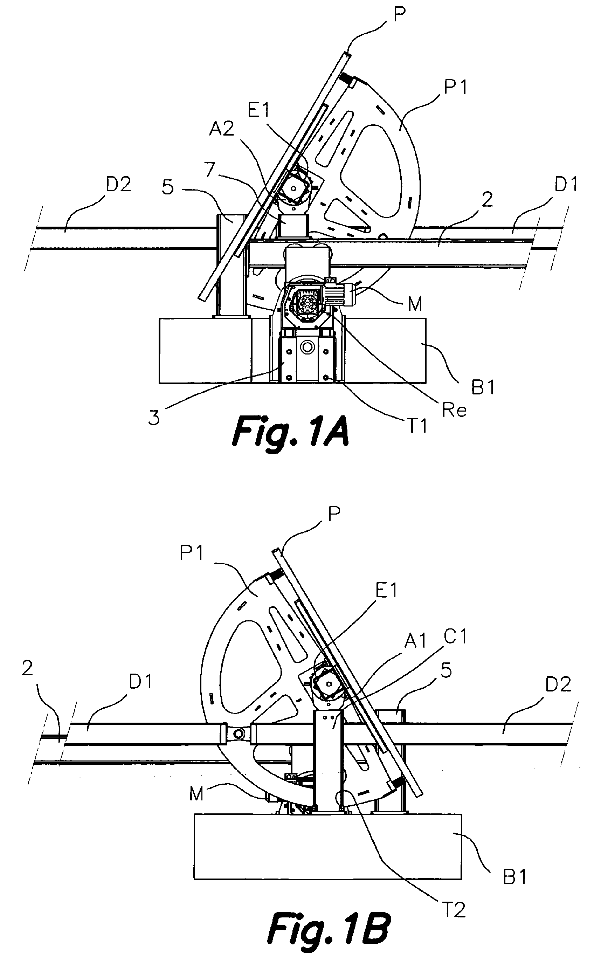

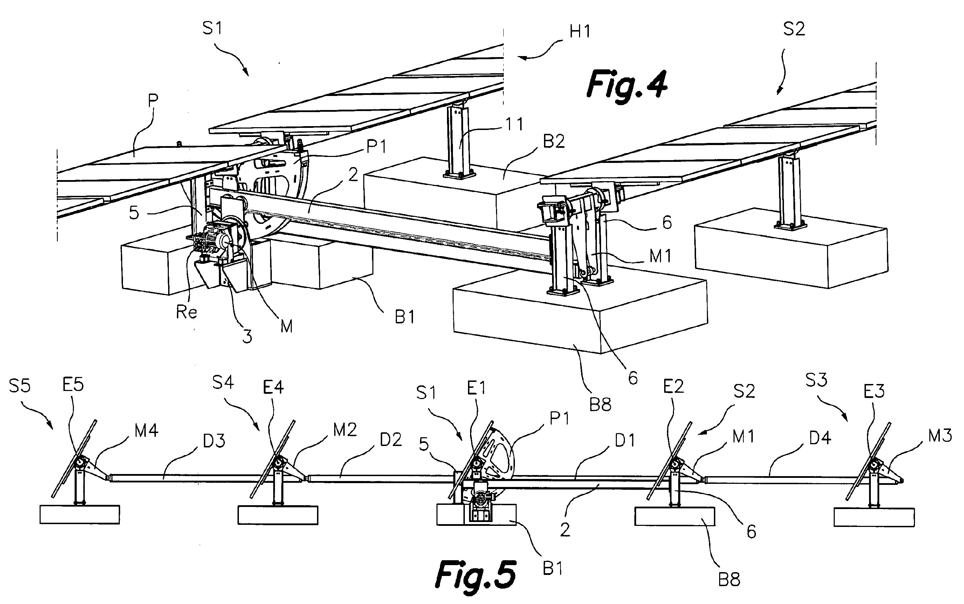

Firstly, in reference to Figures 1A, 1B and 4, in which the solar tracker proposed by the first aspect of the invention appears in detail, for an embodiment for which the latter comprises:
- a row H1 of coplanar and adjacent solar panels P secured to a horizontal common rotating shaft E1;
- a support structure in which the common rotating shaft E1 is rotatably mounted, wherein said support structure comprises a column or beam C1, which for the embodiment illustrated has a H cross-section, with a first end C1a secured to an annular bearing element A1, such as a bearing, through which the rotatable common rotating shaft E1 is arranged, and a second end C1b secured to the support base B1; and
- actuation means for rotating the common rotating shaft E1 for the purpose of orienting the row H of solar panels with respect to the position of the sun, said actuation means comprising a geared motor M in connection with a part P1 in the form of a circular sector, particularly a semicircular part, secured to the common rotating shaft E1, coaxially with the same or with its geometric axis slightly displaced with respect to E1.

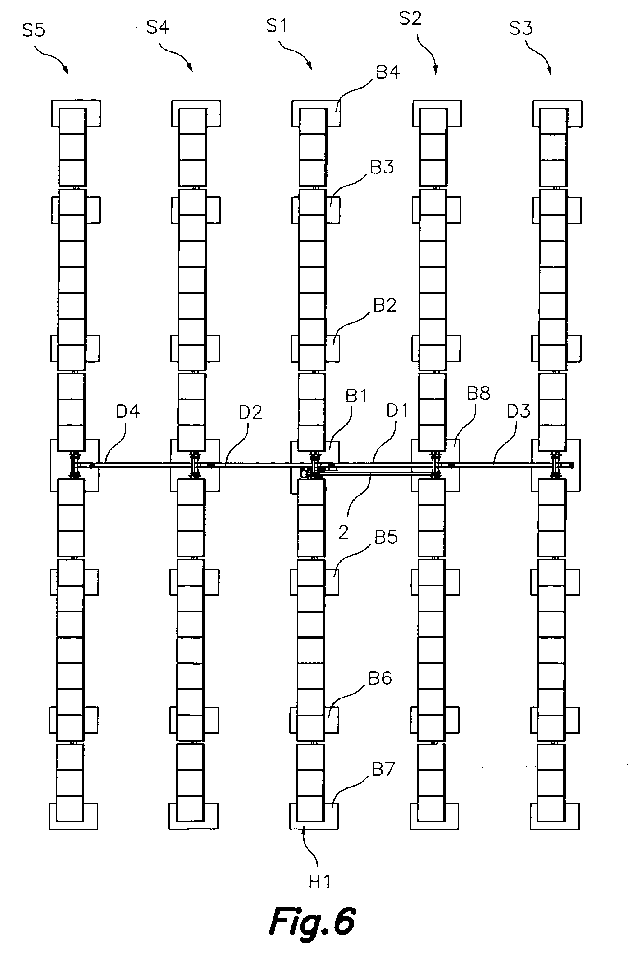

In Figure 4 only part of the row H1 of panels P is seen, the rest have not been illustrated so that the elements of the solar tracker S1 proposed by the first aspect of the invention can be seen in greater detail. The complete row H1 is seen in Figure 6, illustrating a solar power installation which incorporates the tracker S1.

As seen in said Figures 1A, 1B and 4, the tracker proposed comprises a support base B1 attached to the ground (not illustrated), or to any other support surface considered convenient, in which the support structure, particularly the beam C1, and the geared motor M is secured by corresponding securing means, such as screws T2 for the case of the beam C1, and screws T1 for securing the geared motor M to the support base B1.

In particular, the geared motor M is linked to an outer reducing phase Re, both secured to the support base B1 through a frame or support part 3.

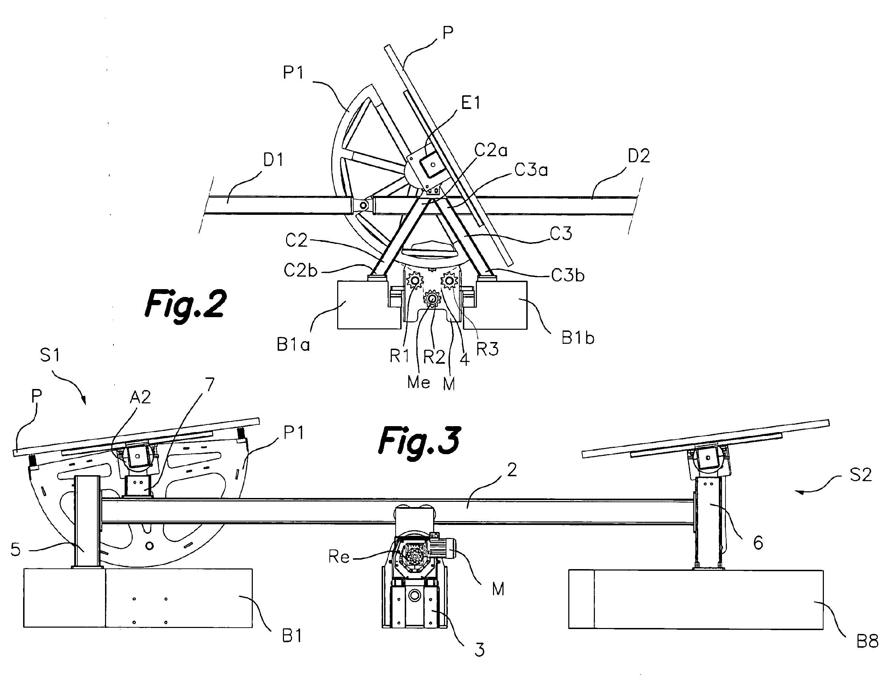

The geared motor M, or the geared motor M plus the outer reducing stage Re assembly, is connected to the semicircular part P1 by means of a traction operated flexible element which for the embodiment of Figures 1A, 1B and 4 has not been illustrated, but which is of the same type illustrated in Figure 2, for the alternative embodiment depicted therein, which will subsequently be described.

Continuing with the description of the securing means for securing the geared motor M to the support base B1, through the frame 3, the latter are releasable securing means for securing/releasing the geared motor M with respect to the support base B1, which releasing, for the case where the securing means are screws T1, is performed by simply unscrewing them from the support base B1.

Generally such releasing is done to perform geared motor M maintenance work (or its replacement if necessary). For facilitating such maintenance work, the solar tracker comprises, as seen particularly in Figures 3 and 4, a rail 2 in which the geared motor M, and the outer reducing stage Re together with the frame 3 is guided, for removing them in a guided manner from the support base B1 once released from the same, carrying them for example to the space available between two solar trackers, the one proposed by the invention, indicated as S1 in Figures 3 and 4, and the adjacent one indicated as S2.

For the embodiment illustrated by said Figures 3 and 4, said rail 2 is secured to a vertical beam 5 secured to the support base B1 and to another beam 6 secured to a support base B8 of said adjacent tracker S2 (the tracker S2 particularly comprises two beams 6, located on either side of a crank M1), although for other non-illustrated embodiments, the rail 2 can be extended from S1 to said available space and secured to the ground without the need of reaching the tracker S2.

As seen in Figures 1B and 4, the beam 5 is laterally displaced according to the direction of the rail 2 with respect to the beam C1, in order to not interfere with the arrangement of the geared motor M in the support base B1, for which the latter adopts an L-shaped in plant view, the beam 5 being secured on one of the branches of the L and the beam C1 being secured on the other branch of said L, in an inside side of which the frame 3 is secured.

Figure 3 shows, secured on the rail 2, a small beam portion 7 secured to a corresponding annular bearing element A2, through which the common rotating shaft E1 is rotatably arranged, in order to better support the weight of the shaft E1 and of the elements which the latter supports.

The tracker S1 comprises a plurality of additional support structures, particularly vertical beams, one of which is illustrated in Figure 4 indicated by reference number 11, in which the common rotating shaft E1 is rotatably mounted at different points distanced length-wise, and a plurality of support bases B2-B7 (see Figure 6) in each of which one of said beams is secured.

Figure 2 illustrates an alternative embodiment for which the proposed solar tracker has a support structure comprising two parallel trestles, on either side of the mentioned part P1 in the form of a circular sector, each of them formed by two beams converging at a first end being secured in an annular bearing element A1, through which the common rotating shaft E1 is rotatably arranged, said beams being secured at second ends in the mentioned support base B1 and the geared motor M being arranged between the two beams of one or both of said trestles.

Figure 2 only illustrates one of said trestles formed by beams C2 and C3, wherein the mentioned converging first ends have been indicated as C2a-C3a and the mentioned second ends as C2b-C3b.

It can be seen in Figure 2 how for an embodiment illustrated therein the support base B1 comprises two blocks B1a, B1b separated from one another, each of said second ends C2b-C3b of said beams C2-C3 being secured to a respective block of said two blocks B1a, B1b, and the geared motor M secured to the two blocks B1a, B1b.

Said Figure 2 shows how the actuation means of the tracker illustrated therein comprise a traction operated flexible element 4, indicated symbolically, such as a chain, which travels along cogwheels R1, R2, R3, one of which, in particular R2, is connected to the shaft Me of the geared motor M to be displaced by the same, said chain 4 being secured at its two end to two respective points of the semicircular part P1, for rotationally displacing it by traction.

A second aspect of the invention relates to a solar power installation comprising a solar tracker S1 such as that proposed by the first aspect of the invention, a plurality of analogous solar trackers S2, S3, S4, S5, the actuation means of which lack a geared motor, and transmission mechanisms for transmitting the rotation of the geared motor M to all the solar trackers S2-S5.

As particularly seen in Figure 5, said transmission mechanism comprises a series of connecting rods D1-D4 and a series of cranks M1-M4, each of them connected to a respective common rotating shaft E2-E5 of one of said solar trackers S2-S5.

Particularly two of said connecting rods D1, D2 are articulately connected at one end to the part P1 in the form of a circular sector (see in detail in Figures 1B and 2), and at their other ends to two respective cranks M1, M2 of two S2, S4 of said solar trackers, as illustrated in Figure 5. The rest of the connecting rods D3, D4 are articulately connected at each of their ends to a respective crank M3, M4 of the rest of the solar trackers S3, S5, interconnecting all the cranks M1-M4 and said part P1 in the form of a circular sector, of all the solar trackers S1-S5, such that the movement produced by the geared motor M of the solar tracker S1 is transmitted to the cranks M1-M4 of the rest of the solar trackers S2-S5, and to the rotating shafts E2-E5 which are secured to the same.

A person skilled in the art will be able to introduce changes and modifications to the embodiments described without departing from the scope of the invention as defined in the attached claims.

## Claims

1. A single-axis solar tracker of the type comprising:
- at least one row (H1) of coplanar and adjacent solar panels (P), secured to a horizontal common rotating shaft (E1);
- at least one support structure wherein said common rotating shaft (E1) is rotatably mounted,
- actuation means for rotating said common rotating shaft (E1) for the purpose of orienting said row (H1) of solar panels with respect to the position of the sun, said actuation means comprising at least one geared motor (M) in connection with at least one part (P1) in the form of a circular sector secured to said common rotating shaft (E1), coaxially with the same or with its geometric axis slightly displaced therefrom,
said solar tracker being **characterized in that** it comprises at least one support base (B1) attached to the ground wherein said at least one support structure and said geared motor (M) are secured.

2. The solar tracker according to claim 1, **characterized in that** said at least one support structure comprises at least one column (C1) with a first end (C1a) secured to an annular bearing element (A1), through which said common rotating shaft (E1) is rotatably arranged, and a second end (C1b) secured to said at least one support base (B1).

3. The solar tracker according to claim 2, **characterized in that** it comprises a single support base (B1), and **in that** said geared motor (M) is secured to said support base (B1) such that the output rotation shaft thereof is aligned with said common rotating shaft (E1) in the same vertical plane.

4. The solar tracker according to claim 1, **characterized in that** said support structure comprises at least two parallel trestles, on either side of the mentioned part (P1) in the form of a circular sector, each of them formed by two beams (C2-C3) converging at a first end (C2a-C3a) being secured in an annular bearing element (A1), through which the mentioned common rotating shaft (E1) is rotatably arranged, said beams (C2-C3) being secured at second ends (C2b-C3b) in the mentioned at least one support base (B1), and the geared motor being arranged between the two beams (C2-C3) of at least one of said trestles.

5. The solar tracker according to claim 4, **characterized in that** said support base (B1) comprises at least two blocks (B1a, B1b) separated from one another, each of said second ends (C2b-C3b) of said beams (C2-C3) being secured to one respective block of said two blocks (B1a, B1b).

6. The solar tracker according to claim 5, **characterized in that** said geared motor (M) is secured to said two blocks (B1a, B1b).

7. The solar tracker according to any of the preceding claims, **characterized in that** said geared motor (M) is secured to said support base (B1) through a frame or support part (3) of the geared motor (M).

8. The solar tracker according to any of the preceding claims, **characterized in that** the width of each panel, transversally to the mentioned common rotating shaft (E1), is greater than the distance between said common rotating shaft (E1) and said support base (B1).

9. The solar tracker according to any of the preceding claims, **characterized in that** it comprises a plurality of additional support structures (11) wherein said common rotating shaft (E1) is rotatably mounted at different points distanced length-wise, and a plurality of support bases (B2-B7), in each of which at least one of said support structures (11) is secured.

10. The solar tracker according to claim 1, **characterized in that** said actuation means comprise a traction operated flexible element (4) which travels along several cogwheels (R1, R2, R3), at least one (R2) of which in connection with the shaft (Me) of said geared motor (M) to be displaced by the same, said chain (4) being secured at its two ends to two respective points of said semicircular part (P1) for displacing it rotationally by traction.

11. The solar tracker according to any of the preceding claims, **characterized in that** it comprises releasable securing means for securing/releasing said geared motor (M) from the support base (B1), and **in that** it comprises a rail (2) wherein said geared motor (M) is guided, for removing the geared motor (M) in a guided manner from the support base (B1) once released from the same.

12. A solar power installation comprising a solar tracker (S1) according to any one of the preceding claims, a plurality of analogous solar trackers (S2, S3, S4, S5), the actuation means of which lack a geared motor, and transmission mechanisms for transmitting the rotation of the geared motor (M) to all the solar trackers.

13. The solar power installation according to claim 12, **characterized in that** said transmission mechanisms comprise a series of connecting rods (D1-D4) and a series of cranks (M1-M4), each of them connected to a respective common rotating shaft (E2-E5) of one of said analogous solar trackers (S2-S5).

14. The solar power installation according to claim 13, **characterized in that** two of said connecting rods (D1, D2) are articulately connected at one end to said part (P1) in the form of a circular sector, and at their other ends to two respective cranks (M1, M2) of two (S2, S4) of said solar trackers, and the rest of the connecting rods (D3, D4) are articulately connected at each of their ends to a respective crank (M3, M4) of the rest of said solar trackers (S3, S5), interconnecting all the cranks (M1-M4) and said part (P1) in the form of a circular sector, of all the solar trackers (S1-S5), such that the movement produced by the geared motor (M) of the solar tracker (S1) according to one of claims 1 to 11 is transmitted to the cranks (M1-M4) of the rest of solar trackers (S2-S5), and to the rotating shafts (E2-E5) which are secured thereto.
